# EUROPÄISCHE PATENTSCHRIFT

(11) **EP 3 320 553 B1**
(45) Veröffentlichungstag und Bekanntmachung des Hinweises auf die Patenterteilung: **11.09.2019**
(21) Anmeldenummer: 16732492.0
(22) Anmeldetag: 09.06.2016
(51) Int. Cl.: H01H 9/54, H01H 33/59, H01H 9/02, H01H 9/50, H01L 31/02, H01H 1/20

(54) **TRENNVORRICHTUNG ZUR GLEICHSTROMUNTERBRECHUNG**
SEPARATING DEVICE FOR DIRECT CURRENT INTERRUPTION
DISPOSITIF DE SÉPARATION DESTINÉ À INTERROMPRE LE FLUX DE COURANT CONTINU

(30) Priorität: 08.07.2015 DE 102015212802
(43) Veröffentlichungstag der Anmeldung: 16.05.2018
(73) Patentinhaber: Ellenberger & Poensgen GmbH, 90518 Altdorf (DE)
(72) Erfinder: KÖPF, Hendrik-Christian, 38106 Braunschweig (DE); WILKENING, Ernst-Dieter, 38108 Braunschweig (DE)
(74) Vertreter: FDST Patentanwälte
(86) Internationale Anmeldenummer: PCT/EP2016/063156
(87) Internationale Veröffentlichungsnummer: WO 2017/005450

(56) Entgegenhaltungen:
- WO-A1-2011/018113
- DE-U1-202009 004 198
- JP-A- 2015 050 080
- US-A- 4 920 448

## Beschreibung

Die Erfindung betrifft eine Trennvorrichtung zur Gleichstromunterbrechung zwischen einer Gleichstromquelle und einer elektrischen Einrichtung, mit einem stromführenden mechanischen Schalter und mit einer mit diesem verschalteten Halbleiterschalter. Es werden hierbei unter einer Gleichstromquelle insbesondere ein Photovoltaikgenerator (PV-Generator, Solaranlage) und unter einer elektrischen Einrichtung insbesondere ein Wechselrichter verstanden.

Aus der DE 20 2008 010 312 U1 ist eine photovoltaische Anlage (PV-Anlage) oder Solaranlage mit einem sogenannten Photovoltaikgenerator bekannt, der seinerseits aus gruppenweise zu Teilgeneratoren zusammengefassten Solarmodulen besteht, die ihrerseits in Reihe geschaltet sind oder in parallelen Strängen vorliegen, wobei die Gleichstromleistung des Photovoltaikgenerators über einen Wechselrichter in ein Wechselspannungsnetz eingespeist wird. Da eine PV-Anlage systembedingt einerseits dauerhaft einen Betriebsstrom und eine Betriebsspannung im Bereich zwischen 180V (DC) und 1500V (DC) liefert und andererseits - beispielsweise zu Installations-, Montage- oder Servicezwecken sowie insbesondere auch zum allgemeinen Personenschutz - eine zuverlässige Trennung der elektrischen Komponenten oder Einrichtungen von der als Gleichstromquelle wirksamen Photovoltaikanlage gewünscht ist, muss eine entsprechende Trennvorrichtung in der Lage sein, eine Unterbrechung unter Last, d.h. ohne vorheriges Abschalten der Gleichstromquelle, vorzunehmen.

Zur Lasttrennung kann ein mechanischer Schalter (Schaltkontakt) mit dem Vorteil eingesetzt werden, dass bei erfolgter Kontaktöffnung eine galvanische Trennung der elektrischen Einrichtung (Wechselrichter) von der Gleichstromquelle (Photovoltaikanlage) hergestellt ist. Werden demgegenüber zur Lasttrennung leistungsfähige Halbleiterschalter eingesetzt, so treten auch im Normalbetrieb unvermeidbare Leistungsverluste an den Halbleitern auf. Zudem ist mit derartigen Leistungshalbleitern keine galvanische Trennung und damit kein zuverlässiger Personenschutz sichergestellt.

Aus der DE 102 25 259 B3 ist ein als Lasttrenner ausgebildeter elektrischer Steckverbinder bekannt, der nach Art eines Hybridschalters ein Halbleiterschaltelement in Form beispielsweise eines Thyristors im Gehäuse des Wechselrichters sowie Haupt- und Hilfskontakte aufweist, die mit Photovoltaikmodulen verbunden sind. Der bei einem Aussteckvorgang voreilende Hauptkontakt ist dem nacheilenden und mit dem Halbleiterschaltelement in Reihe geschalteten Hilfskontakt parallel geschaltet. Dabei wird das Halbleiterschaltelement zur Lichtbogenvermeidung bzw. Lichtbogenlöschung angesteuert, indem dieser periodisch ein- und ausgeschaltet wird.

Zur Gleichstromunterbrechung kann auch ein hybrider elektromagnetischer Gleichstromschalter mit einem elektromagnetisch betätigten Hauptkontakt und mit einem IGBT (insulated gate bipolar transistor) als Halbleiterschalter vorgesehen sein (DE 103 15 982 A2). Ein derartiger Hybridschalter weist jedoch eine externe Energiequelle zum Betreiben einer Leistungselektronik mit einem Halbleiterschalter auf.

Aus der WO 2010/108565 A1 und der DE 10 2009 004 198 U1 ist ein hybrider Trennschalter mit einem mechanischen Schalter oder Trennelement und einer diesem parallel geschalten Halbleiterelektronik bekannt, die im Wesentlichen zumindest einen Halbleiterschalter, vorzugsweise einen IGBT, umfasst. Die Halbleiterelektronik weist keine zusätzliche Energiequelle auf und ist bei geschlossenem mechanischem Schalter stromsperrend, d. h. praktisch strom- und spannungslos. Die Halbleiterelektronik gewinnt die zu deren Betrieb erforderliche Energie aus der Trennvorrichtung, d. h. aus dem Trennschaltersystem selbst, wozu die Energie des beim Öffnen des mechanischen Schalters entstehenden Lichtbogens genutzt wird. Hierbei ist die Halbleiterelektronik ansteuerseitig derart mit dem mechanisehen Schalter verschaltet, dass bei sich öffnendem Schalter die Lichtbogenspannung über dessen Schaltkontakten infolge des Lichtbogens die Halbleiterelektronik stromleitend schaltet.

Sobald die Halbleiterelektronik stromleitend geschaltet ist, beginnt der Lichtbogenstrom von dem mechanischen Schalter auf die Halbleiterelektronik zu kommutieren. Die entsprechende Lichtbogenspannung bzw. der Lichtbogenstrom lädt hierbei einen Energiespeicher in Form eines Kondensators auf, der sich unter Erzeugung einer Steuerspannung zum lichtbogenfreien Abschalten der Halbleiterelektronik gezielt entlädt. Die vorgegebene Zeitdauer oder Zeitkonstante und somit die Ladedauer des Energiespeichers bzw. Kondensators bestimmt die Lichtbogendauer. Im Anschluss an den Ladevorgang startet ein Zeitglied, während dessen die Halbleiterelektronik lichtbogenfrei stromsperrend gesteuert wird. Die Zeitdauer des Zeitglieds ist dabei auf ein sicheres Löschen eingestellt.

Aus JP 2015-050080A ist eine Trennvorrichtung mit einem mechanischen Schalter bekannt, dem einen Reihenschaltung aus zwei IGBTs parallel geschaltet ist. Diese sind derart mit einer Kontaktbrücke des mechanischen Schalters verbunden, dass bei einer Öffnung des mechanischen Schalters aufgrund des Lichtbogens die IGBTs elektrisch leitend geschaltet werden.

Aus US 4,920,448 A ist eine Trennvorrichtung bekannt, bei der zu einer bewegbaren Kontaktbrücke ein Hilfsschaltkreis parallel geschaltet ist. Der Hilfsschaltkreis weist Halbleiterschalter auf.

Aus WO 2011/018113 A1 ist ein Schutzschalter bekannt, der einen Drehschalter aufweist, zu dem ein Halbleiterschalter parallel geschaltet ist. Hierbei ist die Drehachse zu einem Ende des Drehschalters verschoben, und der Halbleiterschalter ist parallel zu der Drehbrücke und dem Ende geschaltet, welches von der Drehachse am weitesten entfernt ist.

Der Erfindung liegt die Aufgabe zu Grunde, eine besonders geeignete Trennvorrichtung (Hybridschalter oder -elektronik) zur Gleichstromunterbrechung zwischen einer Gleichstromquelle, insbesondere einem Photovoltaikgenerator, und einer elektrischen Einrichtung, insbesondere einem Wechselrichter, mit möglichst hohem Schaltvermögen und insbesondere möglichst hoher Ansteuergeschwindigkeit, d.h. sehr schneller Ansteuerung der Leistungselektronik der Trennvorrichtung anzugeben, wobei zweckmäßigerweise eine Ansteuerung vereinfacht ist, und wobei vorzugsweise eine Sicherheit erhöht ist.

Diese Aufgabe wird erfindungsgemäß gelöst durch die Merkmale des Anspruchs 1. Vorteilhafte Ausgestaltungen und Weiterbildungen sind Gegenstand der Unteransprüche.

Die nachfolgend auch als Hybridschalter bezeichnete Trennvorrichtung ist geeignet, und insbesondere vorgesehen und eingerichtet, einen elektrischen Stromfluss zwischen einer Gleichstromquelle und einer elektrischen Einrichtung zu unterbrechen. Bevorzugt wird die Trennvorrichtung zur Gleichstromunterbrechung zwischen einer Gleichstromquelle und einer elektrischen Einrichtung verwendet. Die Gleichstromquelle ist insbesondere ein Photovoltaikgenerator, beispielsweise mit einer Betriebsspannung im Bereich zwischen 180V (DC) und 1500V (DC), und/oder die elektrischen Einrichtung ist ein Wechselrichter, mittels dessen bei Betrieb ein elektrischer Gleichstrom in einen elektrischen Wechselstrom transformiert wird, der zum Beispiel in ein Versorgernetz eingespeist wird. Zweckmäßigerweise wird die Trennvorrichtung zur Unterbrechung eines elektrischen Gleichstroms zwischen dem Photovoltaikgenerator und dem Wechselrichter verwendet. Beispielsweise wird die Trennvorrichtung zur Unterbrechung eines Wechselstroms herangezogen.

Der mechanische Schalter weist einen ersten Festkontakt und einen zweiten Festkontakt auf. Jeder der beiden Festkontakte ist bevorzugt mit einer Anschlusseinrichtung elektrisch kontaktiert, wie einer Klemme. Im Montagezustand ist hierbei mittels der jeweiligen Klemme beispielsweise der zweite Festkontakt mit der Gleichstromquelle und der erste Festkontakt mit der elektrischen Einrichtung elektrisch kontaktiert. Besonders bevorzugt jedoch ist der erste Festkontakt mit der Gleichstromquelle und der zweite Festkontakt mit der elektrischen Einrichtung elektrisch kontaktiert. Insbesondere erfolgt die Kontaktierung mittels einer Anschlusseinrichtung der Trennvorrichtung, die hierfür geeignet eingerichtet ist. Insbesondere ist die Anschlusseinrichtung für die Aufnahme einer Stromleitung vorgesehen, die beispielsweise einen Querschnitt von 2,5mm², 4mm² oder 6mm² aufweist.

Der Schalter weist ferner eine zwischen einer ersten Position und eine zweiten Position bewegliche Kontaktbrücke auf, die insbesondere aus einem niederohmigen Material, wie beispielsweise einem Metall, erstellt ist. In der ersten Position sind der erste Festkontakt und der zweite Festkontakt mittels der Kontaktbrücke elektrisch kontaktiert. Zweckmäßigerweise liegt die Kontaktbrücke in der ersten Position sowohl an dem ersten Festkontakt als auch an dem zweiten Festkontakt an. Mit anderen Worten ist die Kontaktbrücke in direktem mechanischem Kontakt mit dem ersten Festkontakt und dem zweiten Festkontakt. Bei einem Stromfluss über den mechanischen Schalter fließt folglich der elektrische Strom zwischen dem ersten Festkontakt und dem zweiten Festkontakt über die Kontaktbrücke.

In der zweiten Position ist die Kontaktbrücke zu dem ersten Festkontakt und zu dem zweiten Festkontakt beabstandet. Mit anderen Worten ist die Kontaktbrücke räumlich zu den beiden Festkontakten getrennt. Hierfür wird die Kontaktbrücke beispielsweise transversal verbracht oder rotiert, sodass diese nicht in direktem mechanischem Kontakt mit den beiden Festkontakten ist. Insbesondere sind somit der erste Festkontakt und der zweite Festkontakt elektrisch zueinander isoliert. Zweckmäßigerweise umfasst die Kontaktbrücke einen ersten Bewegkontakt und einen zweiten Bewegkontakt, wobei in der ersten Position der erste Bewegkontakt an dem ersten Festkontakt direkt anliegt, und der zweite Bewegkontakt an dem zweiten Festkontakt direkt anliegt. In der zweiten Position ist der erste Bewegkontakt von dem ersten Festkontakt beabstandet und der zweite Festkontakt ist von dem zweiten Bewegkontakt beabstandet. Die Bewegkontakte sind beispielsweise aus einem gegen einen Abbrand vergleichsweise resistenten Material gefertigt. Insbesondere ist die Kontaktbrücke einstückig ausgestaltet.

Ferner umfasst die Trennvorrichtung einen Halbleiterschalter, insbesondere einen Leistungshalbleiterschalter, der elektrisch mit dem ersten Festkontakt und der Kontaktbrücke elektrisch kontaktiert ist. Mit anderen Worten ist der Halbleiterschaler parallel zur Schaltstrecke zwischen dem ersten Festkontakt und der Kontaktbrücke geschalten. Folglich ist diese Schaltstrecke mittels des Halbleiterschalters überbrückt. Geeigneterweise ist der Halbleiterschalter lediglich mittels der Kontaktbrücke mit dem zweiten Festkontakt elektrisch kontaktierbar, nämlich bei Verbringung der Kontaktbrücke in die erste Position. Beispielsweise ist der Halbleiterschalter ein IGBT oder ein MOSFET. Vorzugsweise ist der Halbleiterschalter mittels einer Reihenschaltung eines IGBT's und eines MOSFET's realisiert.

Wenn die Kontaktbrücke in der ersten Position ist, ist der Halbleiterschalter elektrisch nicht leitend, also stromsperrend. Hierfür ist ein Steuereingang des Halbleiterschalters geeignet kontaktiert. Bei einem Stromfluss über den Schalter und einer Bewegung der Kontaktbrücke in die zweite Position bilden sich zwischen dem ersten Festkontakt und der Kontaktbrücke ein Lichtbogen und zwischen dem zweiten Festkontakt und der Kontaktbrücke ein weiterer Lichtbogen aus, so dass auch bei einer Bewegung der Kontaktbrücke in die zweite Position ein elektrischer Stromfluss über den mechanischen Schalter fortbesteht. Dies tritt insbesondere bei vergleichsweise großen elektrischen Spannungen auf.

Der Steuereingang des Halbleiterschalters ist derart mit dem mechanischen Schalter verschaltet, dass bei der Bewegung der Kontaktbrücke in die zweite Position der Halbleiterschalter stromleitend geschaltet wird. Für die Durchführung des Schaltvorgangs des Halbleiterschalters wird eine Lichtbogenspannung verwendet, die aufgrund des Lichtbogens zwischen dem ersten Festkontakt und der Kontaktbrücke hervorgerufen wird. Sofern aufgrund der an der Trennvorrichtung anliegenden elektrischen Spannung kein Lichtbogen erzeugt wird, wird demnach auch der Halbleiterschalter bei einer Bewegung der Kontaktbrücke von der ersten Position in die zweite Position nicht stromleitend geschaltet.

Aufgrund der beweglichen Kontaktbrücke ist bei einer Stromführung mittels der Trennvorrichtung, also falls sich die Kontaktbrücke in der ersten Position befindet, ein vergleichsweise niederohmiger Kontakt zwischen der Gleichstromquelle und der elektrischen Einrichtung, also insbesondere zwischen den beiden Festkontakten realisiert, so dass ein elektrischer Verlust vergleichsweise gering ist. Mittels des Halbleiterschalters wird, wenn die Kontaktbrücke in die zweite Position bewegt wurde, ein Stromfluss zwischen der Kontaktbrücke und dem ersten Festkontakt geführt, so dass ein Lichtbogen zwischen der Kontaktbrücke und dem ersten Festkontakt zusammenbricht. Hierbei besteht der zwischen dem zweiten Festkontakt und der Kontaktbrücke gebildete weitere Lichtbogen weiter fort. Bei einem Schalten des elektrischen Stroms, der mittels des Halbleiterschalters geführt wird, bricht folglich auch dieser weitere Lichtbogen zusammen, so dass ein elektrischer Stromfluss zwischen dem zweiten Festkontakt und dem ersten Festkontakt unterbunden ist. Folglich ist mittels der Trennvorrichtung eine sichere galvanische Trennung, also eine Gleichstromunterbrechung, zwischen der Gleichstromquelle und der elektrischen Einrichtung, sichergestellt, wobei ausgeschlossen ist, dass ein Stromfluss auch bei einem Schalten der Trennvorrichtung fortbesteht. Zusammenfassend wird bei Schalten der Trennvorrichtung und einer folglichen Bewegung der Kontaktbrücke von der ersten Position in die zweite Position zunächst ein Lichtbogen zwischen dem zweiten Festkontakt und der Kontaktbrücke und zwischen der Kontaktbrücke und dem ersten Festkontakt ausgebildet, so dass ein elektrischer Stromfluss zwischen den beiden Festkontakten, und folglich über die Trennvorrichtung, fortbesteht, auch wenn die hierbei anliegende elektrische Spannung erhöht ist. Die zwischen den beiden Festkontakten anliegende elektrische Spannung besteht hierbei aus der Lichtbogenspannung, die zwischen dem ersten Festkontakt und der Kontaktbrücke anliegt, sowie der weiteren Lichtbogenspannung, die zwischen der Kontaktbrücke und dem zweiten Festkontakt anliegt.

Infolge des Lichtbogens zwischen der Kontaktbrücke und dem ersten Festkontakt wird der Halbleiterschalter stromleitend geschaltet, so dass der Stromfluss zwischen dem ersten Festkontakt und der Kontaktbrücke auf den Halbleiterschalter kommutiert. Der Stromfluss zwischen der Kontaktbrücke und dem ersten Festkontakt erfolgt somit nicht über den Lichtbogen, sondern über den Halbleiterschalter, weswegen der Lichtbogen zwischen dem ersten Festkontakt und der Kontaktbrücke erlischt. Der folglich zwischen dem ersten und zweiten Festkontakt weiter fließende elektrische Strom, der mittels des Halbleiterschalters und des zwischen der Kontaktbrücke und dem zweiten Festkontakt gebildeten weiteren Lichtbogens geführt wird, wird in einem weiteren Schritt mittels Schaltens des Halbleiterschalters unterbrochen, so dass auch der weitere Lichtbogen erlischt.

Der mechanische Schalter ist insbesondere ein Doppelunterbrecher. Der mechanische Schalter ist bevorzugt elektrisch betätigt und umfasst hierfür zweckmäßigerweise eine elektrische Spule. Besonders bevorzugt ist der mechanische Schalter ein elektromagnetischer Schütz. Der elektromagnetische Schütz weist vorzugsweise eine Schließerkonfiguration mit Doppelunterbrechung auf. Auf diese Weise ist vergleichsweise kostengünstig eine zwischen einer ersten und zweiten Position bewegbare Kontaktbrücke bereitgestellt. Derartige mechanische Schalter sind vergleichsweise kostengünstig und in unterschiedlichen Konfigurationen verfügbar, so dass die Trennvorrichtung einerseits vergleichsweise kostengünstig herstellbar ist und andererseits auf unterschiedlichste Anforderungen angepasst werden kann. Insbesondere wird hierbei der elektromechanische Schütz in Abhängigkeit des mittels der Trennvorrichtung geführten elektrischen Stroms ausgewählt.

Beispielsweise umfasst die Trennvorrichtung eine Halbleiterelektronik, die parallel zu dem Halbleiterschalter geschaltet ist. Mittels der Halbleiterelektronik erfolgt insbesondere eine Ansteuerung des Halbleiterschalters, sodass dieser infolge der Lichtbogenspannung stromleitend schaltet. Mit anderen Worten ist der Steuereingang des Halbleiterschalters mit der Halbleiterelektronik elektrisch kontaktiert. Die Halbleiterelektronik umfasst geeigneterweise einen Energiespeicher, wie einen Kondensator. Beispielsweise ist der Energiespeicher direkt mit dem ersten Festkontakt und der Kontaktbrücke elektrisch kontaktiert. Besonders bevorzugt ist der Energiespeicher derart innerhalb der Halbleiterelektronik verschaltet, dass lediglich elektrische Energie in diesen eingeleitet wird, sofern der Lichtbogen besteht. Mit anderen Worten ist der Energiespeicher derart verschaltet, dass sich dieser infolge des Lichtbogens auflädt. Dies erfolgt innerhalb einer Lichtbogendauer, also innerhalb der Zeit, die der Lichtbogen anhält.

Zweckmäßigerweise ist der Steuereingang des Halbleiterschalters mit dem Energiespeicher elektrisch kontaktiert, beispielsweise direkt, oder mittels eines weiteren elektrischen oder elektronischen Bauteils. Folglich liegt aufgrund des Energiespeichers, sofern dieser geladen ist, zwischen dem Steuereingang und einem Anschluss des Halbleiterschalters eine elektrische Spannung an, weswegen der Halbleiterschalter stromleitend schaltet. Auf diese Weise ist eine Ansteuerung des Halbleiterschalters vereinfacht. Folglich muss zum Stromleitendschalten des Halbleiterschalters lediglich die Kontaktbrücke von der ersten Position in die zweite Position verbracht werden. Beispielsweise ist der Steuereingang des Halbleiterschalters mittels einer ohmschen Widerstands an die Kontaktbrücke oder den ersten Festkontakt geführt, und zwar denjenigen der Beiden, der, falls sich die Kontaktbrücke in der zweiten Position befindet, das höhere elektrische Potential aufweist. Mit anderen Worten ist der Steuereingang an den ersten Festkontakt geführt, sofern dieser ein größeres elektrisches Potential aufweist als die Kontaktbrücke, oder aber der Steuereingang ist an die Kontaktbrücke geführt, falls diese ein positiveres, größeres Spannungspotential aufweist, als der erste Festkontakt.

Bevorzugt ist nach Ablauf einer Ladezeit des Energiespeichers, also der Zeit, nach der der Energiespeicher vollständig, zu mindestens 90 % oder zu mindestens 80 % geladen ist, der fließende elektrische Strom infolge des Schaltens des Halbleiterschalters vollständig auf diesen, und insbesondere die Halbleiterelektronik, kommutiert. Mit anderen Worten, bricht nach Ablauf der Ladezeit des Energiespeichers der zwischen dem ersten Festkontakt und der Kontaktbrücke gebildete Lichtbogen zusammen.

Vorzugsweise umfasst die Halbleiterelektronik ein Zeitglied zum lichtbogenfreien Abschalten des Halbleiterschalters. Insbesondere wird der Halbleiterschalter nach Ablauf einer Einschaltzeitspanne abgeschaltet, die sich vorzugsweise direkt, an die Ladezeit des Energiespeichers anschließt. Die Ladezeit ist insbesondere die Lichtbogendauer. Die Einschaltzeitspanne ist derart bemessen, dass der elektrische Widerstand des Halbleiterschalters nach dem Schalten auf einen vergleichsweise geringen Wert abgefallen ist, der zumindest geringer ist als die Lichtbogenspannung. Auf diese Weise ist sichergestellt, dass der Lichtbogen nach Ablauf der Einschaltzeitspanne erloschen ist. Insbesondere ist das Zeitglied auf eine Einschaltzeitspanne zwischen 100µs bis 800µs eingestellt oder derart, dass die Ladezeit und die Einschaltzeitspanne zusammen zwischen 100µs und 800µs, bevorzugt zwischen 200µs und 600µs und beispielsweise gleich 500µs ist. Auf diese Weise ist nach Betätigung der Trennvorrichtung der Gleichstrom nach einer vergleichsweise kurzen Zeitspanne sicher unterbrochen, so dass eine Sicherheit erhöht ist. Beispielsweise ist das Zeitglied mittels des Energiespeichers eingestellt und entspricht der Zeit, die zu einer Entladung des Energiespeichers mittels des stromführenden Halbleiterschalters benötigt ist.

Vorzugsweise wird die Lichtbogendauer mittels der Ladedauer bzw. der Ladekapazität des Energiespeichers bestimmt. Mit anderen Worten wird der Energiespeicher derart ausgewählt und eingestellt, dass in Abhängigkeit der Ladedauer bzw. Ladekapazität die Lichtbogendauer verändert wird. Hierbei bricht insbesondere der Lichtbogen bei einer vollständigen Ladung des Energiespeichers zusammen. Beispielsweise ist der Energiespeicher derart bemessen, dass die Lichtbogendauer maximal zwischen 100µs und 800µs, insbesondere zwischen 200ps und 600µs andauert. Auf diese Weise ist eine thermische und elektrische Belastung der Kontaktbrücke und des ersten Festkontakts aufgrund des Lichtbogens vergleichsweise gering, weswegen eine vergleichsweise große Anzahl an Schaltvorgängen mittels der Trennvorrichtung ausgeführt werden kann, ohne dass eine Zerstörung, also ein Abbrand des ersten Festkontakts bzw. der Kontaktbrücke, eine Funktion beeinträchtigt.

Zweckmäßigerweise ist parallel zu dem Halbleiterschalter ein Überspannungsschutz geschaltet. Im Fall ohmscher-induktiver Lasten wird mittels des Überspannungsschutzes eine gespeicherte induktive Energie abgebaut, so dass nach Schalten der Trennvorrichtung eine anliegende elektrische Spannung reduziert ist, was eine Zerstörung der Trennvorrichtung oder hieran angeschlossener Bauteile vermeidet, wie der elektrischen Einrichtung oder der Gleichstromquelle. Beispielsweise umfasst der Überspannungsschutz einen Varistor, und besteht insbesondere hieraus. Insbesondere ist eine Schwellenspannung des Varistors auf eine maximal an dem Halbleiterschalter und/oder der Halbleiterelektronik anlegbare elektrische Spannung eingestellt. Bei einer elektrischen Spannung, die den Halbleiterschalter oder die Halbleiterelektronik zerstören würde, wird diese folglich mittels des Varistors abgebaut wird. Insbesondere ist die Funktionsweise des Varistors unabhängig von einer Richtung des Stromflusses.

In der zweiten Position sind der zweite Festkontakt und die Kontaktbrücke galvanisch zueinander getrennt, zumindest, falls ein elektrischer Stromfluss über die Trennvorrichtung unterbrochen ist. Insbesondere ist der zweite Festkontakt unter die Kontaktbrücke nicht mittels eines weiteren elektrischen oder elektronischen Bauteils überbrückt. Insbesondere ist die Schaltstrecke zwischen dem zweiten Festkontakt und der Kontaktbrücke elektrisch nicht überbrückt oder zumindest elektrisch nicht überbrückbar. Mit anderen Worten ist zu der mittels des zweiten Festkontakts und der Kontaktbrücke bereitgestellten Schaltstrecke kein weiteres Bauelement parallel geschaltet, wie dies bei der Schaltstrecke der Fall ist, die mittels der Kontaktbrücke und dem ersten Festkontakt gebildet ist. Infolgedessen ist mittels der Trennvorrichtung einerseits eine galvanische Trennung bereitgestellt, nämlich mittels des zweiten Festkontakts unter der Kontaktbrücke, und ferner ist ein sicheres Abschalten eines Lichtbogens realisiert, nämlich aufgrund des Halbleiterschalters, mittels dessen die Schaltstrecke zwischen dem ersten Festkontakt und der Kontaktbrücke überbrückt ist. Zudem ist eine Ansteuerung der Trennvorrichtung vereinfacht, da hierfür lediglich die Kontaktbrücke von der ersten Position in die zweite Position bewegt werden muss. Infolgedessen ist es ermöglicht, eine Ansteuerelektronik der Trennvorrichtung vergleichsweise einfach und kostengünstig zu realisieren, insbesondere falls diese den Energiespeicher aufweist, dessen Ladedauer bzw. Ladekapazität auf die Lichtbogendauer abgestimmt ist, und wobei bei einem entleerten Energiespeicher der Halbleiterschalter stromsperrend ist. Somit wird der Halbleiterschalter bei Bewegen der Kontaktbrücke von der ersten in die zweite Position im Wesentlichen selbständig zunächst in den elektrisch leidenden und nach Ablauf der Ladezeit und der Einschaltzeitspanne, die der Zeitspanne entspricht, die für das Laden und Entladen des Energiespeichers erforderlich ist, erneut in den elektrischen nichtleitenden Zustand versetzt.

Nachfolgend wird ein Ausführungsbeispiel der Erfindung anhand einer Zeichnung näher erläutert. Darin zeigen:
- Fig. 1: schematisch eine zwischen einen Photovoltaikgenerator und einen Wechselrichter geschaltete Trennvorrichtung,
- Fig. 2: ein Blockdiagram der Trennvorrichtung mit einem mechanischen Schalter, der eine Kontaktbrücke umfasst,
- Fig. 3: die Kontaktbrücke in einer ersten Position,
- Fig. 4: die Kontaktbrücke in einer zweiten Position, und
- Fig. 5: einen Schaltplan der Trennvorrichtung.

Einander entsprechende Teile sind in allen Figuren mit den gleichen Bezugszeichen versehen.

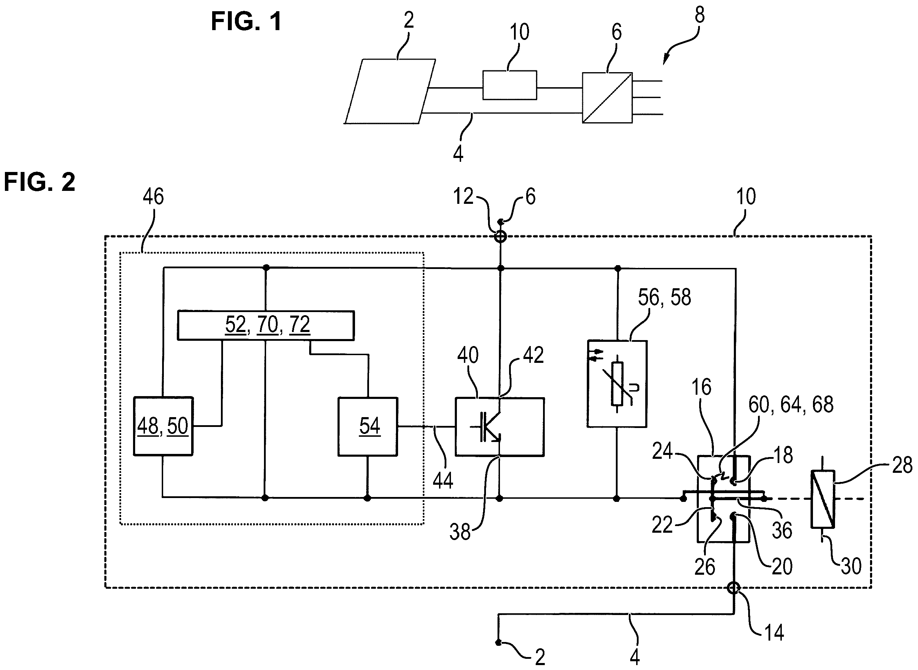

In Fig. 1 ist schematisch ein als Gleichstromquelle 2 fungierender Photovoltaikgenerator dargestellt, der eine Anzahl von nicht gezeigten einzelnen Photovoltaikmodulen mit Photovoltaikzellen umfasst. Bei Betrieb wird mittels des Photovoltaikgenerators eine elektrische Gleichspannung zwischen 180V (DC) und 1500V (DC) bereitgestellt. Mittels einer Stromleitung 4 ist der Photovoltaikgenerator 2 mit einer als ein Wechselrichter 6 ausgestalteten elektrischen Einrichtung elektrisch kontaktiert. Infolge der anliegenden elektrischen Spannung erfolgt ein mittels der Stromleitung 4 geführter Stromfluss zwischen dem Photovoltaikgenerator 2 und dem Wechselrichter 6. Mittels des Wechselrichters 6 wird der bereitgestellte elektrische Strom, der aufgrund des Photovoltaikgenerators 2 prinzipbedingt als Gleichstrom vorliegt, und der eine Stromstärke von einigen Ampere aufweist, in einen Wechselstrom transformiert und beispielsweise in ein dreiphasiges Versorgernetz 8 eingespeist. Hierfür umfasst der Wechselrichter 6 eine Anzahl an Leistungshalbleiterschaltern, die in einer Brückenschaltung miteinander elektrisch kontaktiert sind. In die Stromleitung 4 ist eine Trennvorrichtung 10 zur Gleichstromunterbrechung eingebracht, mittels derer der Stromfluss zwischen dem Photovoltaikgenerator 2 und dem Wechselrichter 6 unterbrochen werden kann.

In Fig. 2 ist als Blockdiagramm die Trennvorrichtung 10 dargestellt, die mit dem Wechselrichter 6 und dem Photovoltaikgenerator 2 mittels der Stromleitung 4 elektrisch kontaktiert ist. Hierfür umfasst die Trennvorrichtung 10 eine erste Anschlusseinrichtung 12 und eine zweite Anschlusseinrichtung 14, jeweils in Form einer Klemme. Die erste Anschlusseinrichtung 12 ist mittels eines Stromkabels oder dergleichen direkt mit dem Wechselrichter 6 und die zweite Anschlusseinrichtung 14 mittels eines weiteren Stromkabels oder dergleichen mit dem Photovoltaikgenerator 2 elektrisch kontaktiert. Mittels der beiden Anschlusseinrichtungen 12, 14 werden die beiden Stromkabel fest an der Trennvorrichtung 10 gehalten. Folglich dienen die beiden Anschlusseinrichtungen 12, 14 sowohl der elektrischen als auch der mechanischen Kontaktierung.

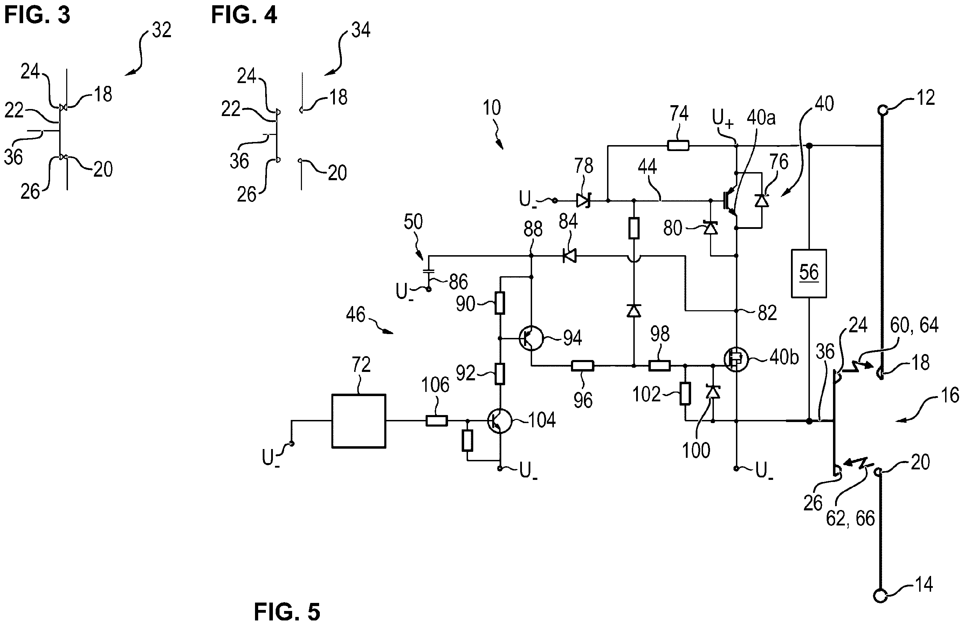

Die Trennvorrichtung 10 umfasst einen mechanischen Schalter 16 in Form eines elektromagnetischen Schütz in Schließerkonfiguration mit Doppelunterbrechung. Der mechanische Schalter 16 weist einen ersten Festkontakt 18 auf, der elektrisch direkt mit der ersten Anschlusseinrichtung 12 kontaktiert ist. Ferner umfasst der mechanische Schalter 16 einen zweiten Festkontakt 20, der elektrisch direkt mit der zweiten Anschlusseinrichtung 14 elektrisch kontaktiert ist. Weiterhin weist der mechanische Schalter 16 eine Kontaktbrücke 22 mit einem ersten Bewegkontakt 24 und einem zweiten Bewegkontakt 26 auf. Die Kontaktbrücke 22 ist mechanisch mit einem elektromagnetischen Antrieb 28 verbunden, der mit einer Signalleitung 30 beaufschlagt ist. Entsprechend der mittels der Signalleitung 30 übermittelten Signale, insbesondere dem Anliegen einer elektrischen Spannung, wird die Kontaktbrücke 22 entweder in eine Fig. 3 gezeigte erste Position 32 oder in eine in Fig. 4 gezeigten Position 34 verbracht.

In der ersten Position 32 liegt der erste Bewegkontakt 24 der einstückigen Kontaktbrücke 22 mechanisch direkt an dem ersten Festkontakt 18 und der zweite Bewegkontakt 26 mechanisch direkt an dem zweiten Festkontakt 20 an. Infolgedessen ist mittels der Kontaktbrücke 22 eine niederohmige Verbindung zwischen dem ersten Festkontakt 18 und dem zweiten Festkontakt 20 erstellt. Bei der zweiten Position 34 ist die Kontaktbrücke 22 von dem ersten Festkontakt 18 und dem zweiten Festkontakt 20 beabstandet. Mit anderen Worten ist zwischen dem ersten Bewegkontakt 24 und dem ersten Festkontakt 18 sowie zwischen dem zweiten Bewegkontakt 26 und dem zweiten Festkontakt 20 ein Luftspalt gebildet, der insbesondere größer als 2mm, 3mm, 4mm oder 5mm und vorzugsweise kleiner als 10mm, 8mm oder 6mm ist. Zur Verbringung der Kontaktbrücke 22 von der ersten Position 32 zur zweiten Position 34 wird diese transversal verbracht.

Die Kontaktbrücke 22 weist ferner eine Kontaktstelle 36 auf, die mit einem ersten Eingang 38 eines Halbleiterschalters 40 elektrisch kontaktiert ist. Ein zweiter Eingang 42 des Halbleiterschalters ist direkt mit dem ersten Festkontakt 18 und der ersten Anschlusseinrichtung 12 elektrisch kontaktiert. Unter elektrisch direkt kontaktiert wird insbesondere verstanden, dass diejenigen Bauteile bei Betrieb im Wesentlichen das gleiche elektrische Potential aufweisen. Mittels Anlage eines elektrischen Potentials an einem Steuereingang 44 des Halbleiterschalters 40 ist ein Stromfluss zwischen dem ersten Eingang 38 und dem zweiten Eingang 42 über den Halbleiterschalter 40 ein- und ausschaltbar.

Der Steuereingang 44 ist mittels einer Halbleiterelektronik 46 gesteuert, die parallel zu dem Halbleiterschalter 40 geschaltet ist, also die folglich mit der Kontaktstelle 36 und dem ersten Festkontakt 18 elektrisch kontaktiert ist. Die Halbleiterelektronik 46 weist ein Netzteil 48 mit einem Energiespeicher 50 sowie eine Steuer-/Schutzeinheit 52 auf, die mittels des Netzteils 48 mit elektrischer Energie versorgt wird. Die Steuer- /Schutzeinheit 52 dient der Ansteuerung einer Ausgangstreiberstufe 54, mittels derer Signale der Steuer- /Schutzeinheit 52 in ein Signal zur Ansteuerung des Halbleiterschalters 40 transformiert werden. Mittels dieses Signals wird der Steuereingang 44 zur Ansteuerung des Halbleiterschalters 40 beaufschlagt.

Die Trennvorrichtung 10 weist ferner einen Überspannungsschutz 56 auf, der einen Varistor 58 umfasst. Der Überspannungsschutz 56 ist parallel zu der Halbleiterelektronik 46 sowie dem Halbleiterschalter 40 geschaltet und folglich mit der Kontaktstelle 36 der Kontaktbrücke 22 und dem ersten Festkontakt 18 des mechanischen Schalters 16 elektrisch kontaktiert.

Im Normalbetrieb befindet sich die Kontaktbrücke 22 in der ersten Position 32, sodass ein elektrischer Stromfluss zwischen der ersten Anschlusseinrichtung 12 und der zweiten Anschlusseinrichtung 14 ermöglicht ist. Hierbei ist der Schalter 16 stromführend und der Halbleiterschalter 40 stromsperrend. Somit ist ein Stromfluss zwischen dem Photovoltaikgenerator 2 und dem Wechselrichter 6 ermöglicht, weswegen die mittels des Photovoltaikgenerators 2 umgewandelte elektrische Energie in das Versorgernetz 8 eingespeist werden kann. Sofern der Photovoltaikgenerator 2 von dem Versorgernetz 8 getrennt werden soll, beispielsweise aufgrund von Wartung oder einer Fehlfunktion, wird die Trennvorrichtung 10 betätigt. Hierbei wird mittels des elektromechanischen Antriebs 28 die Kontaktbrücke 22 von der ersten Position 32 in die zweite Position 34 verbracht. Aufgrund der anliegenden elektrischen Spannung bildet sich zwischen dem ersten Festkontakt 18 und dem ersten Bewegkontakt 24 ein Lichtbogen 60 und zwischen dem zweiten Festkontakt 20 und dem zweiten Bewegkontakt 26 ein weiterer Lichtbogen 62 (Fig. 5) aus.

Infolgedessen besteht trotz geöffneter Schaltkontakte des mechanischen Schalters 16 ein elektrischer Stromfluss zwischen den beiden Anschlusseinrichtungen 12, 14 fort. Aufgrund der beiden Lichtbögen 60, 62 ist jedoch die zwischen den beiden Anschlusseinrichtungen 12, 14 anliegende elektrische Spannung im Vergleich zu einer direkten Anlage der Bewegkontakte 24, 26 an den jeweils zugeordneten Festkontakten 18, 20 erhöht. Die elektrische Spannung setzt sich zusammen aus einer Lichtbogenspannung 64, die aufgrund des Lichtbogens 60 hervorgerufen wird, und aus einer weiteren Lichtbogenspannung, die aufgrund des weiteren Lichtbogens 62 hervorgerufen wird. Die Lichtbogenspannung 64 liegt ferner an der Halbleiterelektronik 46 an. Infolgedessen wird der Energiespeicher 50 aufgeladen. Mittels des Energiespeichers 50 wird die Steuer- /Schutzeinheit 52 und die Ausgangstreiberstufe 54 bestromt und der Steuereingang 44 des Halbleiterschalters 40 mit einem elektrischen Potential beaufschlagt. Infolgedessen wird der Halbleiterschalter 40 stromleitend geschalten, so dass ein elektrischer Stromfluss zwischen dessen beider Eingänge 42, 38 ermöglicht ist.

Der zwischen den beiden Eingängen 38, 42 herrschende elektrische Widerstand ist somit geringer als die elektrische Spannung des Lichtbogens 64, weswegen dieser erlischt, was nach einer Zeitdauer erfolgt, die sich zeitlich direkt an das Bewegen der Kontaktbrücke 22 in die zweite Position 34 anschließt. Diese Zeitdauer wird auch als Lichtbogendauer 68 bezeichnet, also die Dauer, die der Lichtbogen 64 anhält. Folglich ist der Stromfluss zwischen der Kontaktstelle 36 und der ersten Anschlusseinrichtung 12 auf den Halbleiterschalter 40 kommutiert und zwischen dem ersten Festkontakt 18 und dem ersten Bewegkontakt 24 erfolgt kein elektrischer Stromfluss. Der weitere Lichtbogen 62 besteht weiter fort, so dass auch nach der Lichtbogendauer 68 ein Stromfluss zwischen den beiden Anschlusseinrichtungen 12, 14 fortbesteht. Die Lichtbogendauer 68 beträgt hierbei im Wesentlichen 500µs. Nach einer sich hieran anschließenden Einschaltzeitspanne 70, die mittels eines Zeitglieds 72 der Steuer- /Schutzeinheit 52 realisiert wird, wird der Halbleiterschalter 40 elektrisch sperrend geschaltet, also ein Stromfluss zwischen den beiden Eingängen 38, 42 unterbunden, was mit Anlage eines geeigneten elektrischen Potentials an dem Steuereingang 44 mittels der Halbleiterelektronik 46 erfolgt. Infolgedessen erlischt der weitere Lichtbogen 62, und der zweite Festkontakt 20 und die Kontaktbrücke 22 sind galvanisch getrennt. Folglich sind auch der Photovoltaikgenerator 2 und der Wechselrichter 6 voneinander galvanisch getrennt. Sofern induktive Lasten mit der Stromleitung 4 elektrisch kontaktiert sind, wird eine Überspannung, die zu einer Zerstörung des Halbleiterschalters 40, der Halbleiterelektronik 46 oder des mechanischen Schalters 16 führen würden, mittels des Überspannungsschutzes 56 abgebaut.

Fig. 5 zeigt einen vergleichsweise detaillierten Schaltplan der Trennvorrichtung 10, die auch als hybrider Trennschalter bezeichnet ist. Der Halbleiterschalter 40 umfasst einen ersten Halbleiterschalter 40a und einen zweiten Halbleiterschalter 40b, die parallel zum Überspannungsschutz 56 geschaltet sind. Die Halbleiterelektronik 46 weist den Energiespeicher 50 und das Zeitglied 72 auf. Die Halbleiterelektronik 46 ist, vorzugsweise über einen Widerstand oder eine Widerstandsreihe 74, mit der ersten Anschlusseinrichtung 12 verbunden. Das Gate eines vorzugsweise als erster Halbleiterschalter 40a eingesetzten IGBT's bildet den Steuereingang 44 des Halbleiterschalters 40. Dieser Steuereingang 44 ist über die Halbleiterelektronik 46 an den ersten Festkontakt 18 geführt.

Der erste Halbleiterschalter (IGBT) 40a ist in einer Kaskodenanordnung mit dem zweiten Halbleiterschalter 40b in Form eines MOSFET in Reihe geschaltet. Das an dem erste Halbleiterschalter 40a anliegende Potential U₊ ist stets größer als das Potential U- auf der gegenüberliegenden Schalterseite, an der der zweite Halbleiterschalter (MOSFET) 40b an die Kontaktstelle 36 geführt ist. Das Pluspotential U₊ beträgt 0V, wenn der mechanische Schalter 16 geschlossen ist, also die Kontaktbrücke 22 in der ersten Position 32 ist.

Der erste Halbleiterschalter (IGBT) 40a ist mit einer Freilaufdiode 76 beschaltet. Eine erste Zehnerdiode 78 ist anodenseitig gegen das Potential U- und kathodenseitig mit dem Gate (Steuereingang 44) des ersten Halbleiterschalters (IGBT) 40a verbunden. Eine zweite Zehnerdiode 80 ist kathodenseitig wiederum mit dem Gate (Steuereingang 44) und anodenseitig mit dem Emitter des ersten Halbleiterschalters (IGBT) 40a verbunden.

An einen Mitten- oder Kaskodenabgriff 82 zwischen dem ersten und zweiten Halbleiterschalter 40a bzw. 40b der Kaskodenanordnung ist anodenseitig eine Diode 84 geführt, die kathodenseitig über einen als Energiespeicher 50 dienenden Kondensator 86 gegen das Potential U- geschaltet ist. Auch können mehrere Kondensatoren 86 den Energiespeicher 50 bilden. Über einen anodenseitigen Spannungsabgriff 88 zwischen der Diode 84 und dem Energiespeicher 50 bzw. dem Kondensator 86 ist ein mit ohmschen Widerständen 90 und 92 beschalteter Transistor 94 über weitere Widerstände 96 und 98 mit dem Gate des zweiten Halbleiterschalters (MOSFET) 40b verbunden. Eine weitere Zehnerdiode 100 mit parallelem Widerstand 102 ist kathodenseitig mit dem Gate und anodenseitig mit der Source des zweiten Halbleiterschalters (MOSFET) 40b verbunden.

Basisseitig wird der Transistor 94 über einen Transistor 104 angesteuert, der seinerseits basisseitig über einen ohmschen Widerstand 106 mit dem beispielsweise als Monoflopp ausgeführten Zeitglied 72 verbunden ist. Basis-Emitter-seitig ist der Transistor 104 zudem mit einem weiteren Widerstand 108 beschaltet.

Bei geschlossenem mechanischem Schalter 16 ist der elektrische Kontakt zwischen den Festkontakten 18, 20 niederohmig, während der mittels des ersten und zweiten Halbleiterschalters 40a, 40b gebildete Halbleiterschalter 40 hochohmig und somit stromsperrend ist. Vor Öffnung des mechanischen Schalters 16 beträgt die dort anfallende elektrische Spannung praktisch 0V und steigt mit dem Öffnen der Kontaktbrücke 22 des mechanischen Schalters 72 sprunghaft auf einen für die Lichtbögen 60, 62 charakteristischen Wert mit den typischen Lichtbogenspannung 64, 66 von beispielsweise 20V bis 30V an. Das Pluspotential U₊ geht somit gegen diese Lichtbogenspannung 64 ≈ 30V, wenn der mechanische Schalter 16 öffnet.

Während der dem Kontaktöffnungszeitpunkt nachfolgenden Zeitdauer (Lichtbogenzeitintervall) beginnt bereits die Kommutierung des im Wesentlichen dem Lichtbogenstrom entsprechenden Schalterstroms von dem Lichtbogen 60 auf den Halbleiterschalter 40. Während des Lichtbogenzeitintervalls teilt sich praktisch der Lichtbogenstrom zwischen dem Halbleiterschalter 40 und dem Lichtbogen 60 auf. Während dieses Lichtbogenzeitintervalls wird der Energiespeicher 50 geladen. Die Zeitdauer ist dabei derart eingestellt, dass einerseits genügend Energie für ein zuverlässiges Ansteuern der Halbleiterelektronik 46 zur Verfügung steht, insbesondere zu deren Abschaltung während eines Zeitraums im Anschluss an das Lichtbogenzeitintervalls. Andererseits ist das Lichtbogenzeitintervall ausreichend kurz, so dass ein unerwünschter Kontaktabbrand oder -verschleiß des Schalters 16 bzw. dessen Schalterkontakte 18, 20, 24, 26 vermieden ist.

Mit Beginn des Lichtbogens 60 und somit bei Entstehung der Lichtbogenspannung 64, wird über den Widerstand 74 der erste Halbleiterschalter (IGBT) 40a zumindest soweit durchgesteuert, dass eine ausreichende Ladespannung und ein ausreichender Lichtbogen- bzw. Ladestrom für die Kondensatoren 86 und somit für den Energiespeicher 50 zur Verfügung steht. Vorzugsweise wird hierzu mit der entsprechenden Beschaltung des ersten Halbleiterschalters (IGBT) 40a mit dem Widerstand 74 und der Zehnerdiode 78 ein Regelkreis der Elektronik 46 geschaffen, mit dem die Spannung am Kaskodenabgriff 82 auf beispielsweise U_{Ab} = 12V (DC) eingestellt ist. Hierbei fließt durch den dem Pluspotential U₊ nahen ersten Halbleiterschalter (IGBT) 40a ein Bruchteil des Lichtbogenstroms.

Die anfallende Abgriffsspannung dient im Wesentlichen der Versorgung der Transistoren 94 und 104 sowie des Zeitglied 72 und des Energiespeichers 50 der Elektronik 46. Die anodenseitig mit dem Kaskodenabgriff 82 und kathodenseitig mit dem Kondensator 86 verbundene Diode 84 verhindert einen Rückfluss des Ladestroms aus den Kondensatoren 86 in Richtung des Potentials U-. Ist genügend Energie im Kondensator 86 und somit im Energiespeicher 50 enthalten, und ist demzufolge eine ausreichend hohe Steuer- oder Schaltspannung am Spannungsabgriff 88 vorhanden, so steuern der Transistor 104 und in Folge dessen der Transistor 94 durch, so dass auch die beiden Halbleiterschalter 40a, 40b vollständig durchsteuern. Der Lichtbogenstrom fließt aufgrund des im Vergleich zum sehr hohen Widerstand der zwischen dem ersten Festkontakt 18 und dem ersten Bewegkontakt 24 gebildeten Trennstrecke des mechanischen Schalters 16 praktisch ausschließlich über den Halbleiterschalter 40, der aufgrund der nunmehr durchgesteuerten Halbleiterschalter 40a, 40b einen wesentlich geringeren Widerstand aufweist.

Das Pluspotential U₊ geht somit erneut gegen 0V, wenn der Schalterstrom auf den Halbleiterschalter 40 kommutiert. In Folge dessen verlöscht der Lichtbogen 60 zwischen den Kontakten 18, 24 des mechanischen Schalters 16, wohingegen der weitere Lichtbogen 62 fortbesteht.

Die Ladekapazität und somit die in dem Kondensator 86 enthaltene Speicherenergie ist derart bemessen, dass der Halbleiterschalter 40 den elektrischen Strom für eine vom Zeitglied 72 vorgegebene Zeitdauer trägt. Diese Zeitdauer kann auf beispielsweise 500µs eingestellt sein. Die Bemessung dieser Zeitdauer und damit die Festlegung des Zeitgliedes 72 richtet sich im Wesentlichen nach den anwendungsspezifischen oder typischen Zeitdauern für ein vollständiges Verlöschen des Lichtbogens 60 sowie nach einer ausreichenden Abkühlung des dabei gebildeten Plasmas. Wesentliche Maßgabe ist hierbei, dass nach erfolgter Abschaltung der Elektronik 46 mit daraufhin stromsperrenden Halbleiterschalter 40 am nach wie vor geöffneten mechanischen Schalter 16 bzw. über dessen Kontakte 18, 20, 24, 26 kein erneuter Lichtbogen 60, 62 entstehen kann.

### Bezugszeichenliste

- 2: Photovoltaikgenerator
- 4: Stromleitung
- 6: Wechselrichter
- 8: Versorgernetz
- 10: Trennvorrichtung
- 12: erste Anschlusseinrichtung
- 14: zweite Anschlusseinrichtung
- 16: mechanischer Schalter
- 18: erster Festkontakt
- 20: zweiter Festkontakt
- 22: Kontaktbrücke
- 24: erster Bewegkontakt
- 26: zweiter Bewegkontakt
- 28: elektromechanischer Antrieb
- 30: Signalleitung
- 32: erste Position
- 34: zweite Position
- 36: Kontaktstelle
- 38: erster Eingang
- 40: Halbleiterschalter
- 40a: erster Halbleiterschalter
- 40b: zweiter Halbleiterschalter
- 42: zweiter Eingang
- 44: Steuereingang
- 46: Halbleiterelektronik
- 48: Netzteil
- 50: Energiespeicher
- 52: Steuer- /Schutzeinheit
- 54: Ausgangstreiberstufe
- 56: Überspannungsschutz
- 58: Varistor
- 60: Lichtbogen
- 62: weiterer Lichtbogen
- 64: Lichtbogenspannung
- 66: weitere Lichtbogenspannung
- 68: Lichtbogendauer
- 70: Einschaltzeitspanne
- 72: Zeitglied
- 74: Widerstand
- 76: Freilaufdiode
- 78: erste Zehnerdiode
- 80: zweite Zehnerdiode
- 82: Kaskodenabgriff
- 84: Diode
- 86: Kondensator
- 88: Spannungsabgriff
- 90: ohmscher Widerstand
- 92: ohmscher Widerstand
- 94: Transistor
- 96: ohmscher Widerstand
- 98: ohmscher Widerstand
- 100: weitere Zehnerdiode
- 102: ohmscher Widerstand
- 104: Transistor
- 106: ohmscher Widerstand
- 108: ohmscher Widerstand

- U₊: Pluspotential
- U-: Minuspotential

## Patentansprüche

1. Trennvorrichtung (10) zur Gleichstromunterbrechung zwischen einer Gleichstromquelle (2) und einer elektrischen Einrichtung (6), mit einem mechanischem Schalter (16), der einen ersten Festkontakt (18), einen zweiten Festkontakt (20) und eine zwischen einer ersten Position (32) und einer zweiten Position (34) bewegliche Kontaktbrücke (22) aufweist, wobei in der ersten Position (32) der erste Festkontakt (18) und der zweite Festkontakt (20) mittels der Kontaktbrücke (22) elektrisch kontaktiert und in der zweiten Position (34) die Kontaktbrücke (22) zu dem ersten Festkontakt (18) und dem zweiten Festkontakt (20) beabstandet ist, und wobei die Kontaktbrücke (22) und der erste Festkontakt (18) mit einem Halbleiterschalter (40) elektrisch kontaktiert sind, der stromsperrend ist, wenn die Kontaktbrücke (22) in der ersten Position (32) ist, und wobei ein Steuereingang (44) des Halbleiterschalters (40) derart mit dem mechanischen Schalter (16) verschaltet ist, dass bei einer Bewegung der Kontaktbrücke (22) in die zweite Position (34) eine infolge eines Lichtbogens (60) über den Schalter (16) erzeugte Lichtbogenspannung (64) den Halbleiterschalter (40) stromleitend schaltet, wobei in der zweiten Position (34) der zweite Festkontakt (20) und die Kontaktbrücke (22) galvanisch getrennt sind.

2. Trennvorrichtung (10) nach Anspruch 1,
**dadurch gekennzeichnet,**
**dass** der mechanische Schalter (16) ein elektromechanisches Schütz in Schließerkonfiguration mit Doppelunterbrechung ist.

3. Trennvorrichtung (10) nach Anspruch 1 oder 2,
**dadurch gekennzeichnet,**
**dass** eine Halbleiterelektronik (46) parallel zu dem Halbleiterschalter (40) geschaltet ist, die einen Energiespeicher (50) aufweist, der sich infolge des Lichtbogens (60) innerhalb einer Lichtbogendauer (68) auflädt.

4. Trennvorrichtung (10) nach Anspruch 1 oder 2,
**dadurch gekennzeichnet,**
**dass** der Steuereingang (44) des Halbleiterschalters (40) mit dem Energiespeicher (50) elektrisch kontaktiert ist

5. Trennvorrichtung (10) nach Anspruch 3 oder 4,
**gekennzeichnet durch**,
ein Zeitglied (72) zum lichtbogenfreien Abschalten des Halbleiterschalters (40) nach Ablauf einer sich an die Ladezeit des Energiespeichers (50) anschließende Einschaltzeitspanne (70).

6. Trennvorrichtung (10) nach einem der Ansprüche 3 bis 5,
**dadurch gekennzeichnet,**
**dass** die Lichtbogendauer (68) durch die Ladedauer bzw. -kapazität des Energiespeichers (50) bestimmt ist.

7. Trennvorrichtung (10) nach Anspruch 6,
**dadurch gekennzeichnet,**
**dass** die Lichtbogendauer (68) zwischen 100µs und 800µs ist.

8. Trennvorrichtung (10) nach einem der Ansprüche 1 bis 7,
**dadurch gekennzeichnet,**
**dass** parallel zu dem Halbleiterschalter (40) ein Überspannungsschutz (56) geschaltet ist.

9. Trennvorrichtung (10) nach Anspruch 8,
**dadurch gekennzeichnet,**
**dass** der Überspannungsschutz (56) einen Varistor (58) umfasst.

## Claims

1. Isolating apparatus (10) for interrupting direct current between a direct current source (2) and an electrical device (6), having a mechanical switch (16), which has a first fixed contact (18), a second fixed contact (20) and a contact bridge (22) that is able to move between a first position (32) and a second position (34), wherein, in the first position (32), the first fixed contact (18) and the second fixed contact (20) are electrically contact-connected by means of the contact bridge (22) and, in the second position (34), the contact bridge (22) is spaced apart from the first fixed contact (18) and the second fixed contact (20), and wherein the contact bridge (22) and the first fixed contact (18) are electrically contact-connected to a semiconductor switch (40), which does not conduct current when the contact bridge (22) is in the first position (32), and wherein a control input (44) of the semiconductor switch (40) is interconnected with the mechanical switch (16) in such a way that, when the contact bridge (22) moves into the second position (34), an arc voltage (64) generated as a result of an arc (60) across the switch (16) causes the semiconductor switch (40) to become current-conducting, wherein, in the second position (34), the second fixed contact (20) and the contact bridge (22) are galvanically isolated.

2. Isolating apparatus (10) according to Claim 1, **characterized in that**
the mechanical switch (16) is an electromechanical contactor in normally-open configuration with double interruption.

3. Isolating apparatus (10) according to Claim 1 or 2,
**characterized in that**
a semiconductor electronics system (46) is connected in parallel with the semiconductor switch (40), said semiconductor electronics system having an energy store (50), which is charged as a result of the arc (60) within an arc period (68).

4. Isolating apparatus (10) according to Claim 1 or 2,
**characterized in that**
the control input (44) of the semiconductor switch (40) is electrically contact-connected to the energy store (50) .

5. Isolating apparatus (10) according to Claim 3 or 4,
**characterized by**
a timer (72) for the arc-free disconnection of the semiconductor switch (40) after a switch-on time period (70) following the charging time of the energy store (50) has elapsed.

6. Isolating apparatus (10) according to one of Claims 3 to 5,
**characterized in that**
the arc period (68) is determined by the charging period or charging capacitance of the energy store (50) .

7. Isolating apparatus (10) according to Claim 6, **characterized in that**
the arc period (68) is between 100 µs and 800 µs.

8. Isolating apparatus (10) according to one of Claims 1 to 7,
**characterized in that**
an overvoltage protection system (56) is connected in parallel with the semiconductor switch (40).

9. Isolating apparatus (10) according to Claim 8, **characterized in that**
the overvoltage protection system (56) comprises a varistor (58).

## Revendications

1. Dispositif de coupure (10) pour l'interruption d'un courant continu entre une source de courant continu (2) et un dispositif électrique (6), comprenant un commutateur mécanique (16), lequel comprend un premier contact fixe (18), un deuxième contact fixe (20) et un pont de contact (22) mobile entre une première position (32) et une deuxième position (34), dans lequel, dans la première position (32), le premier contact fixe (18) et le deuxième contact fixe (20) sont mis en contact électrique au moyen du pont de contact (22) et, dans la deuxième position (34), le pont de contact (22) est espacé du premier contact fixe (18) et du deuxième contact fixe (20), et dans lequel le pont de contact (22) et le premier contact fixe (18) sont mis en contact électrique au moyen d'un commutateur à semi-conducteur (40), lequel empêche la conduction de courant lorsque le pont de contact (22) est dans la première position (32), et dans lequel une entrée de commande (44) du commutateur à semi-conducteur (40) est connectée au commutateur mécanique (16) de telle sorte que, lors d'un déplacement du pont de contact (22) dans la deuxième position (34), une tension d'arc électrique (64) générée du fait d'un arc électrique (60) par l'intermédiaire du commutateur (16) commute le commutateur à semi-conducteur (40) de manière à permettre la conduction du courant, dans lequel, dans la deuxième position (34), le deuxième contact fixe (20) et le pont de contact (22) sont séparés galvaniquement.

2. Dispositif de coupure (10) selon la revendication 1, **caractérisé en ce que** le commutateur mécanique (16) est un disjoncteur électromécanique en configuration normalement ouverte avec double sectionnement.

3. Dispositif de coupure (10) selon la revendication 1 ou 2, **caractérisé en ce qu'**une électronique à semi-conducteur (46) est connectée en parallèle avec le commutateur à semi-conducteur (40) et comporte un accumulateur d'énergie (50) qui se charge sous l'effet de l'arc électrique (60) au cours d'une période d'arc électrique (68).

4. Dispositif de coupure (10) selon la revendication 1 ou 2, **caractérisé en ce que** l'entrée de commande (44) du commutateur à semi-conducteur (40) est mise en contact électrique avec l'accumulateur d'énergie (50).

5. Dispositif de coupure (10) selon la revendication 3 ou 4, **caractérisé par** un temporisateur (72) destiné à ouvrir le commutateur à semi-conducteur (40) sans formation d'arc électrique après écoulement d'une période de temps de connexion (70) qui fait suite au temps de charge de l'accumulateur d'énergie (50).

6. Dispositif de coupure (10) selon l'une des revendications 3 à 5, **caractérisé en ce que** la durée de l'arc électrique (68) est déterminée par la durée ou la capacité de charge de l'accumulateur d'énergie (50).

7. Dispositif de coupure (10) selon la revendication 6, **caractérisé en ce que** la durée de l'arc électrique (68) est comprise entre 100µs et 800µs.

8. Dispositif de coupure (10) selon l'une des revendications 1 à 7, **caractérisé en ce qu'**un dispositif de protection contre les surtensions (56) est monté en parallèle avec le commutateur à semi-conducteur (40).

9. Dispositif de coupure (10) selon la revendication 8, **caractérisé en ce que** le dispositif de protection contre les surtensions (56) comprend une varistance (58).
